# EUROPÄISCHE PATENTANMELDUNG

(11) **EP 2 068 259 A1**
(43) Veröffentlichungstag der Anmeldung: **10.06.2009**
(21) Anmeldenummer: 07122324.2
(22) Anmeldetag: 04.12.2007
(51) Int. Cl.: G06F 17/50, H01L 27/02

(54) **Verfahren und System zur Ueberpruefung des ESD-Verhaltens von integrierten Schaltungen auf Schaltungsebene**

(71) Anmelder: X-FAB Semiconductor Foundries AG, 99097 Erfurt (DE)
(72) Erfinder: Bergmann, Lars, 99089 Erfurt (DE); Konrad, Angela, 99096 Erfurt (DE); Frank, Markus, 99099 Erfurt (DE)
(74) Vertreter: Leonhard, Frank Reimund

(57) **Zusammenfassung**

Ein System und ein Verfahren zur Prüfung des ESD-Verhaltens, wobei eine Schaltung (7) automatisch auf Schaltplanebene geprüft wird, indem technologiespezifische ESD-Daten für alle in der Schaltung auftretenden Komponenten in einer Datenbank (2) bereitgestellt und zur Auswertung des ESD-Verhaltens herangezogen werden, ohne dass aufwändige Schaltungssimulationen erforderlich sind, beispielsweise auf Basis von Frontend- oder Backend-Daten, unter Berücksichtigung von "Parasites" im Layout.

## Beschreibung

Die Erfindung betrifft die Herstellung integrierter Schaltungen und betrifft insbesondere die Bewertung diverser Signalwege der integrierten Schaltung in einer frühen Phase der Herstellung. Früh ist vor der eigentlichen Herstellung des integrierten Schaltungschips, in Bezug auf ihr Verhalten bei Auftreten von statischen Entladungen.

Die zunehmende Integration von immer mehr Funktionen und die Einsparung an Chipfläche machen integrierte Schaltungen empfindlicher im Bezug auf Schäden durch elektrostatische Entladung. In integrierten Schaltungen oder anderen Bauelementen der Mikrotechnologie, in denen Schaltungselemente und Signalwege für elektrische Signale vorhanden sind, werden leitfähigen Halbleitergebiete in Form von PN-Übergängen, Leitungen, und dergleichen, Metallgebiete, Isolatoren etc. innerhalb sehr kleiner Gebiete angeordnet, um damit die für die Schaltung erforderlichen Bauelemente, etwa Transistoren, Kondensatoren, Widerstände und dergleichen zu bilden. Beispielsweise werden in der MOS-Technologie Feldeffekttransistoren eingesetzt, die zwei stark dotierte Halbleitergebiete aufweisen, die wiederum durch ein schwach dotiertes Kanalgebiet voneinander getrennt sind. Die Leitfähigkeit des Kanalgebiets wird dabei durch eine Elektrode, die üblicherweise als Gate-Elektrode bezeichnet wird, gesteuert, die von dem Kanalgebiet durch eine Isolationsschicht getrennt ist. Bei zunehmender Verringerung der Transistorabmessungen ist in der Regel auch die Dicke dieser Isolierschicht zu verringern, um die Steuerbarkeit des Kanalgebiets weiterhin in der erforderlichen Weise auch bei den geringeren Abmessungen aufrecht zu erhalten. Mit geringer werdender Dicke des Isolationsmaterials reduziert sich aber auch die Fähigkeit, höheren Spannungen ohne Durchschlag zu widerstehen. Derartige Gate-Dielektrika sind somit bei Auftreten von höheren Spannung besonders gefährdet. Dies gilt in mehr oder weniger ausgeprägter Form auch für die anderen Bauelemente in einer integrierten Schaltung, da aufgrund der voranschreitenden Reduzierung der Bauelementefläche auch zwangsläufig die Länge der entsprechenden Isolationsstrecken, wie die Dicke der Gate-Dielektrika, abnimmt.

Aus diesem Grund nimmt die Empfindlichkeit von Bauelementen in modernen integrierten Schaltungen in Bezug auf das Auftreten von Überspannungen zu; deren Auftreten ist zum Teil unvermeidlich beim Umgang der integrierten Schaltungen. So können bereits statische Aufladungen eines Menschen, die durch Reibung entstehen, bspw. beim Gehen auf Teppichböden oder dergleichen, eine Größe von mehreren 1000 V erreichen, wobei die angesammelten Ladungen dann bei Kontakt mit einem leitenden Pfad abfließen können oder unter Erzeugung eines leitenden Pfads aufgrund nicht ausreichender Isolationsfestigkeit der Isolierstrecke sich in Form eines elektrischen Durchschlags entladen. Bei einer derartigen elektrostatischen Entladung oder ESD (electrostatic discharge) können trotz der relativ geringen beteiligten Ladungsmengen relativ hohe Ströme von einigen Ampere fließen, da die Entladungsströme nur innerhalb sehr kurzer Zeiten von einigen Nanosekunden bis einige zehn Nanosekunden auftreten. Zur Charakterisierung derartiger Entladungserscheinungen wurden auch entsprechende Modelle definiert, die die Bedingungen beschreiben, die bei statischen Entladungen auftreten. Mittels dieser Modelle kann das Verhalten von integrierten Schaltungen quantitativ untersucht und festgelegt werden für die jeweiligen Bedingungen, die durch das spezielle Entladungsmodell repräsentativ sind. Beispielsweise gibt es ein Modell für statische Entladungen, die bei Aufladung von Personen auftreten, wobei elektrische Parameter, wie der Spannungsbereich, der Innenwiderstand, die Dauer und die Höhe des Entladungsstroms auf Werte festgelegt sind, die derartige Entladungsereignisse bei Aufladungen von Personen im wesentlichen wiedergeben.

Bei einer elektrostatischen Entladung über eine integrierte Schaltung können somit Schäden hervorgerufen werden, die zu irreversibler Schädigung einer Isolationsschicht führen, die zu einer thermischen Schädigung aufgrund des hohen Stromes führen oder zu einer allmählichen Veränderung des Bauteilverhaltens aufgrund von beispielsweise höheren Leckströmen führen, insbesondere wenn diese Entladungen häufiger auftreten. Diese Schädigungen können auch in beliebiger Kombination auftreten.

Aus diesem Grund steigt die Forderung nach mehr ESD-Robustheit bzw.
ESD-Festigkeit. ESD-Schäden und die damit verbundenen Ausfälle stellen häufig den Grund für Re-Designs dar. Bei Erkennung einer ESD-Schwachstelle muss die Gestaltung der integrierten Schaltung geändert werden, um eine für die Anforderung geeignete ESD-Robustheit zu erreichen. Durch die Implementierung bekannter ESD-Schutzkonzepte mittels der durch die Halbleitertechnologien bereitgestellten ESD-Schutzstrukturen, bspw. in Form von Bauelementen wie speziellen Transistoren, Dioden, etc., die die hohen Ströme innerhalb der kurzen Zeiten ohne Schaden ableiten können, ist es heutzutage möglich, auch für ESD-empfindliche Schaltungen die geforderte hohe ESD-Festigkeit auf Schaltkreisebene sicherzustellen. Die Bedingung hierfür ist jedoch die korrekte Implementierung der ESD-Schutzkonzepte und die Einhaltung der für die Technologie definierten ESD-Design-Rules. Die ESD-Design-Rules oder die Entwurfsvorschriften geben dabei die Prozesse und die Materialien sowie entsprechende Abmessungen an, die für spezielle Technologie zu verwenden sind, um die geforderte ESD-Festigkeit erreichen zu können. Dazu sind aber auch die erforderlichen ESD-Schutzkonzepte, also die Schaltungselemente, die geeignete ESD-Entladungspfade bereitstellen, effizient im Schaltungsaufbau einzurichten. Daher ist eine sorgfältige Prüfung speziell der hochkomplexen Schaltungen in Mixed-Signal-Anwendungen notwendig. Dies sind Anwendungen, in denen analoge Schaltungen und digitale Schaltungen in einem Schaltungsaufbau vorhanden sind, und in Automotive Anwendungen, bspw. im Fahrzeugbereich, Einsatz finden.

ESD-Experten benötigen bereits einen signifikanten Teil ihrer Arbeitszeit zur Prüfung von Schaltungen auf mögliche ESD-Schwachstellen. In Bezug auf die ESD-Problematik weniger geübte Schaltungsentwickler können ESD-Schwachstellen leicht übersehen. Daher ist während der Gestaltungsphase der Halbleiterschaltung, im Design-Flow, ein intelligentes System zur Prüfung eines IC-Designs vorteilhaft, um den Aufwand bei komplexen Schaltungen zu begrenzen und gleichzeitig die durch ESD verursachte Fehlerrate zu reduzieren. Es ist dabei vorteilhaft, diese Prüfung bereits in einem möglichst frühen Entwurfsstadium durchzuführen. Dazu sind Werkzeuge verfügbar, die auf Layoutebene arbeiten, wie ein von X-FAB entwickelter Layout-ESD-Checker oder andere in der Literatur vorgestellte Lösungen, die z.B. ebenfalls auf Layoutbasis oder auf Basis einer ESD-Schaltungssimulation arbeiten und einen hohen Grad an Automatisierung bieten, jedoch einen Aufwand für die Simulation und Auswertung erfordern. Der in diesen bekannten Systemen angewendete Ansatz einer Gesamtchip-ESD-Schaltungssimulation erfordert die Verwendung von ESD-Kompaktmodellen für ESD-Schutzstrukturen, für die zu schützenden Schaltungselemente und die parasitären Komponenten der Schaltung. Zur Generierung dieser Kompaktmodelle ist ein hoher Aufwand für Kalibrierung und Parameterextraktion notwendig. Weitere Probleme bei der Gesamtchip ESD-Schaltungssimulation ergeben sich durch numerische Instabilitäten, die z.B. aus der Modellierung des komplexen, physikalischen Verhaltens der Bauelemente unter ESD-Stress oder der umfangreichen Simulationsnetzliste, die die eigentliche Schaltung mit ESD-Schutzelementen, parasitären Komponenten bis hin zum IC-Package enthält, resultieren. Die ESD-Designprüfung kann indes auch so erweitert werden, dass ein Layout analysierbar ist. In der praktischen Arbeit realisierbare Lösungen zur ESD-Schaltungssimulation ergeben sich im Rahmen dieser Techniken im wesentlichen nur durch sinnvolle Vereinfachungen, die jedoch zu einer geringeren Abdeckung der ESD-Prüfung im Hinblick auf die ESD-Prüfung führen können.

Aufgrund dieser Sachlage ist es **Aufgabe der Erfindung,** die ESD-Prüfung in einem möglichst frühen Entwicklungsstadium bei reduziertem Aufwand und mit hoher Fehlerabdeckung zu ermöglichen.

Erfindungsgemäß wird die Aufgabe gemäß einem Aspekt gelöst durch ein Verfahren zur Prüfung des Verhaltens einer Schaltung im Entwurfsstadium in Bezug auf elektrostatische Entladungen (Anspruch 1). Das Verfahren umfasst einen Schritt des Bereitstellens von parametrisierten Daten, die das Verhalten bei elektrostatischer Entladung beschreiben, für jede in der Schaltung verwendete Schaltungskomponente in einer Datenbank. Ferner werden Schaltungskomponenten in einem auf elektrostatische Entladung zu prüfenden Signalweg der Schaltung ermittelt und die von zu den ermittelten Schaltungskomponenten zugehörigen parametrisierten Daten werden aus der Datenbank abgerufen. Schließlich wird mindestens ein für das Verhalten bei elektrostatischer Entladung charakteristischer Parameterwert für den zu prüfenden Signalweg unter Benutzung der zugehörigen parametrisierten Daten ermittelt.

Das erfindungsgemäße Verfahren beruht somit nicht auf der ESD-Schaltungssimulation mittels Kompaktmodellen, sondern auf der Analyse der Schaltung, also der für die Schaltung vorgesehenen Schaltungskomponenten und ihren elektrischen Verbindung(en) untereinander, unter Berücksichtigung des ESD-Verhaltens der individuellen Bauelemente oder kleinerer Funktionsblöcke, ohne dass eine Simulation der Schaltung erforderlich ist. Die Grundlage hierfür bilden die Daten für die Charakterisierung des ESD-Verhaltens der Schaltungskomponenten, die vorteilhaft sämtliche in einer Technologie zur Verfügung stehenden Bauelemente (primitive devices) umfassen.

In einer weiteren Ausführungsform kennzeichnet der mindestens eine charakteristische Parameterwert eine Entladungsfestigkeit zwischen Anschlusspunkten der Schaltung, so dass unmittelbar eine Information über das ESD-Verhalten zwischen zwei beliebigen Anschlussstiften der Schaltung, auf die eine hohe elektrostatische Spannung einwirkt, erhalten wird. Auf diese Weise kann der Schaltungsentwickler rasch auf Grundlage des Schaltplans die Reaktion der Schaltung "virtuell" prüfen und gegebenenfalls den Schaltplan durch Hinzufügen oder Modifizieren der ESD-Schutzkomponenten anpassen.

In einer vorteilhaften Variante kennzeichnet der mindestens eine charakteristische Parameterwert die Spannung und/oder den Strom an einem Anschlusspunkt des zu prüfenden Signalwegs. Die Ausgabe dieser Werte erlaubt auch eine virtuelle quantitative Bewertung der Schaltung, da die sich bei der Entladung ergebende Spannung an dem Anschlussstift und der auftretende Entladestrom ein detailliertes Verständnis des Entladevorgangs ermöglichen und auch Vergleichswerte für eine weitergehende Verifizierung des betrachteten Signalwegs durch eine umfangreichere Simulation auf Layoutebene oder experimentelle Prüfung repräsentieren.

Vorteilhaft wird ein Entladungspfad für den zu prüfenden Signalweg darstellend angezeigt, so dass die ESD-Information in einer für einen Benutzer effizient zu verwertenden Art bereitgestellt wird.

In einer Ausführungsform umfasst das Bestimmen mindestens eines charakteristischen Parameterwertes: Ermitteln eines oder mehrerer Entladepfade durch Anwendung vordefinierter Auswerteregeln auf die abgerufenen parametrisierten Daten. Durch die Implementierung bestimmter Auswerteregeln besteht die Möglichkeit, eine gewünschte Modellierung durch die "objektiven" parametrisierten ESD-Daten vorzunehmen. So können auf der Grundlage der ESD-Daten mit Hilfe der vordefinierten Regeln verschiedene ESD-Modelle, bspw. das HBM (Human Body Model), nachgebildet werden, wobei auch die Möglichkeit besteht, zwischen verschiedenen Auswerteregeln umzuschalten, so dass der gleiche Signalweg auf unterschiedliche Weise bewertet werden kann, ohne dass die Verwendung unterschiedlicher parametrisierter Daten erforderlich ist.

In einer weiteren Ausführungsform umfasst das Verfahren ferner: Auswählen eines in der Schaltung angewendeten Entladungsschutzkonzepts vor dem Bestimmen des mindestens einen charakteristischen Parameterwertes. Aufgrund dieser Auswahl kann die automatische Erkennung von Schaltungskomponenten, die dem ESD-Schutz dienen, verbessert werden.

Dazu wird in einer Ausführungsform zwischen einem Schutzkonzept für Entladung über Anschlussfläche(n) alternativ einem Schutzkonzept für Entladung über Zuleitung(en) der Versorgungsspannung unterschieden (Anspruch 7). Damit ist es bei der Schaltungsanalyse möglich, grundsätzlich das gewählte ESD-Schutzkonzept, Padbasiert oder Power-Rail-basiert zu berücksichtigen. Dies wird vom Benutzer durch die Auswahl vordefinierter oder in ihren Parametern konfigurierbarer Power-Supply-Clampstrukturen spezifiziert (Strukturen, die eine mögliche Entladestrecke mit den Leitungen der Versorgungsspannung im Entladefall verbinden), oder die im Entladefall die positive und negative Versorgungsspannungsleitung elektrisch verbinden, dadurch eine mögliche Entladestrecke über die Leitungen der Versorgungsspannung ermöglichen/definieren und dabei die an den Leitungen der Versorgungsspannung angeschlossene Schaltung vor Überspannung(en) schützen.

In einer weiteren Ausführungsform umfasst das Ermitteln der in dem Signalweg vorhandenen Schaltungskomponenten: Verwenden von parametrisierten Schaltungsdaten, die die elektrischen Eigenschaften der vorhandenen Schaltungskomponenten und deren Verbindungen untereinander spezifizieren. Durch diese Art der Erkennung des Schaltungsaufbaus ergibt sich eine effiziente Anbindung an viele bestehende Systeme zur Darstellung von Schaltungen auf Schaltplanebene, da hier die Schaltungskomponenten anhand ihrer elektrischen Daten zu einer Schaltung zusammengefasst und in unterschiedlichen Abstraktionsstufen zu elektrischen Funktionsblöcken vereint werden. Ferner ist in einer Ausführungsform vorgesehen, auf diese Funktionsblöcke einzuwirken, um eine gewünschte Veränderung der Schaltung zu erreichen, so dass parasitäre Effekte, die nicht durch die parasitären Anteile der Schaltungskomponenten in Form der parametrisierten Schaltungsdaten erfasst sind, sondern durch layoutspezifische oder technologiespezifische Vorgeben eingeführt werden, berücksichtigt werden können. Z.B. können erwartete Leitungswiderstände in Signalpfaden oder Buswiderstände der Leitungsführung der Versorgungsspannungen in Form von Metallwiderständen in die Schaltung, also durch Verwenden von parametrisierten Schaltungsdaten von Metallwiderständen, eingebunden werden.

In einer Ausführungsform werden die parametrisierten Schaltungsdaten mit den zugehörigen parametrisierten Daten verknüpft, um den mindestens einen charakteristischen Parameterwert zu bestimmen. Durch diese Zuordnung der technologiespezifischen ESD-Daten mit den elektrischen Schaltungsdaten wird somit das technologieabhängige ESD-Verhalten in die zu prüfende Schaltung "eingeprägt" und kann dann automatisch unter Verwendung der verknüpften Datensätze ausgewertet werden. Dabei kann durch die Einbeziehung zusätzlicher Schaltungskomponenten, beispielsweise der zuvor genannten Leitungswiderstände, bereits der zugrunde liegenden Schaltung ein gewisses Maß an Technologie-Abhängigkeit verliehen werden, um noch authentischere Ergebnisse zu erhalten, ohne auf komplexe Schaltungsmodelle zurückgreifen zu müssen.

In einer weiteren Ausführungsform umfasst das Verfahren ferner: Zusammenfassen mehrerer Schaltungskomponenten als einzelne Entladungsschutzkomponente und Verknüpfen der einzelnen Entladungsschutzkomponente mit den für diese einzelne Entladungsschutzkomponente in der Datenbank 'hinterlegten' (gespeicherten) parametrisierten Daten. Auf diese Weise können komplexere ESD-Schutzstrukturen automatisch erkannt und mit den geeigneten parametrisierten ESD-Daten verknüpft werden, um das ESD-Verhalten dieser komplexen Schutzkomponente auf Schaltungsebene nachzubilden.

Vorteilhaft ist die einzelne Entladungsschutzkomponente durch mehrere Bipolartransistoren und einen Hochvolt-NMOS-Transistor gebildet. Z.B. werden in Hochspannungsanwendungen häufig ESD-Schutzschaltungen mit durch eine Gate-Vorspannung getriggerten Hochvolt-NMOS Transistoren verwendet. Diese Triggerschaltung, die aus Dioden oder Bipolartransistoren aufgebaut sein können, im Zusammenwirken mit dem Hochvolt NMOS-Transistor wird somit als solche Schaltungs-Struktur erkannt und entsprechend als Makro-Block mit spezieller Snap-Back-Charakteristik behandelt. Die Parameter der Snap-Back-Charakteristik, z.B. Triggerspannung und Triggerstrom, sind dabei der Schaltungs-Konfiguration angepasst.

In einer weiteren Ausführungsform werden die parametrisierten Daten, die das bei elektrostatischer Entladung auftretende Verhalten der Schaltungskomponeten beschreiben, ermittelt. Dies geschieht durch Einprägen 'kurzer' Strompulse in eine Schaltungskomponente und Auswerten einer Strom-Spannungscharakteristik der Schaltungskomponente. Durch die Strom-Spannungscharakteristiken können somit die ESD-Daten technologieabhängig ermittelt werden. Dabei können reale Bauteilkomponenten verwendet werden und/oder das Antwortverhalten der interessierenden Schaltungskomponenten kann durch Simulation ermittelt werden.

Die kurzen Strompulse (Impulse) können mit einer Zeitdauer von mehreren 100 psec bis mehreren 100 nsec mit einer Stromstärke von bis zu 30 A eingeprägt werden (Anspruch 13). Durch diese Stromimpulse werden die realen Verhältnisse bei elektrostatischen Entladungen ausreichend genau nachgebildet, wobei sich die gewonnen Parameter durch Anpassung an verschiedene Modelle als entsprechende parametrisierte ESD-Daten in der Datenbank hinterlegen lassen, so dass die Auswertung auf der Grundlage vereinfachter Regeln durchgeführt werden kann.

Da die Strompulse zeitlich kurz sind, insbesondere als Impulse mit einer Zeitdauer von bevorzugt unter 500 nsec, besonders im Bereich von mehreren 100 psec bis zu 100 nsec, können reale Verhältnisse nachgebildet werden.

Da die Strompulse mit einer Stromstärke von unter 30 A eingeprägt werden, besonders im Bereich zwischen 1 A und 10 A, ist auch vom Strom her ein reales Verhältnis nachbildbar.

In anderen Fällen werden die Antwortdaten ohne eine weitergehende Manipulation verwendet und eine möglicherweise gewünschte Anpassung an unterschiedliche ESD-Modelle wird durch die Implementierung geeigneter Auswerteregeln und Algorithmen erreicht, wie dies zuvor beschrieben ist.

In einer Ausführungsform werden Abschnitte in der Strom-Spannungscharakteristik linearisiert, um die charakteristischen Daten zu ermitteln. Auf diese Weise kann das Verhalten von insbesondere MOS-Transistoren bei Auftreten von ESD effizient dargestellt werden.

In einer Ausführungsform umfassen die parametrisierten Daten einen ersten Datensatz, der eine erste Fertigungstechnologie repräsentiert, und einen zweiten Datensatz, der eine zweite unterschiedliche Fertigungstechnologie repräsentiert. Durch das Vorsehen von ESD-Daten für unterschiedliche Fertigungstechnologien ergibt sich eine höhere Flexibilität bei der Prüfung verschiedener Schaltungen, da die unterschiedlichen Technologien - also die kritischen Abmessungen der Bauteile im integrierten Schaltungschip etc. - sofort aus der Datenbank abrufbar sind. Dabei kann durch Angabe der gewünschten Technologie automatisch der geeignete Datensatz abgerufen und für die ESD-Prüfung verwendet werden.

In einer Ausführungsform repräsentiert die Schaltung den Entwurf einer vollständigen integrierten Schaltung. Durch die Auswertung des ESD-Verhaltens einzelner Schaltungskomponenten ohne Verwendung komplexer Kompaktmodelle, kann somit auch eine sehr komplexe Schaltung eines vollständigen ICs zeiteffizient überprüft und gegebenenfalls modifiziert werden.

Gemäß einem weiteren Aspekt wird die zuvor genannte Aufgabe gelöst durch ein System zur Prüfung des Verhaltens einer Schaltung im Entwurfsstadium bei elektrostatischer Entladung (Anspruch 17). Dazu umfasst das System eine Datenbank, die für alle Schaltungskomponenten der Schaltung parametrisierte Daten enthält, die das Verhalten jeder Schaltungskomponente bei Einprägung eines (kurzen) Strompulses charakterisieren. Ein Funktionsmodul ist vorgesehen zur Identifizierung von Schaltungskomponenten auf der Grundlage von parametrisierten Schaltungsdaten, die die elektrischen Eigenschaften der in der Schaltung verwendeten Schaltungskomponenten und der elektrischen Wechselwirkungen untereinander beschreiben. Das System umfasst zudem ein Auswertemodul, das mit dem Funktionsmodul in Verbindung steht und ausgebildet ist, parametrisierte Daten für die Schaltungskomponenten der Schaltung aus der Datenbank abzurufen, mit den parametrisierten Schaltungsdaten zu verknüpfen und durch vordefinierte Regeln aus den verknüpften parametrisierten Daten zumindest einen für das Verhalten bei elektrostatischer Entladung charakteristischen Parameterwert zu bestimmen.

Durch diesen Aufbau des Systems zur Prüfung des ESD-Verhaltens auf Schaltungsebene, das als ESD-Checker bezeichnet werden kann, werden technologieabhängige ESD-Daten in der Datenbank zur Verfügung gestellt und mit den technologieunabhängigen elektrischen Daten, die den Schaltungsaufbau spezifizieren, verknüpft. Somit kann zu einen der zugrunde liegende Schaltplan der zu prüfenden Schaltung auf einer gewünschten Abstraktionsebene, bspw. funktionelle Blöcke bis herab zur Transistorebene, automatisch erfasst werden und mit einem ESD-Verhalten über die parametrisierten ESD-Daten verknüpft werden, so dass das ESD-Verhalten dann in Abhängigkeit der Schaltungstopologie und der zu verwendenden Technologie ausgewertet werden kann, ohne dass aufwendige Simulationen auf Layoutebene erforderlich sind.

In einer weiteren Ausführungsform weist das System ferner eine Benutzerschnittstelle auf, die ausgebildet ist, eine durch den Benutzer vorzunehmende Auswahl zumindest eines oder mehrerer zu prüfenden Signalwege in der Schaltung vorzunehmen, so dass eine einfache und intuitive Handhabung des Systems ermöglicht wird. Weitere Auswahlmöglichkeiten, die von der Benutzerschnittstelle vorgegeben werden, sind
- eine ESD-Testspannung und/oder
- ein ESD-Testmodell.
   Von der Benutzerschnittstelle vorgegeben werden können auch
- ESD-Schutzelemente der Versorgungsleitung, und zwar aus vordefinierten Makroblöcken;
- eigene Makroblöcke, zum Schutz der Versorgungsleitung(en).

In einer weiteren Ausführungsform ist eine darstellende Anzeigeeinrichtung vorgesehen, auf der der mindestens eine charakteristische Parameterwert angezeigt werden kann, wodurch eine rasche und effiziente Wahrnehmung für einen Benutzer erreicht wird.

Das System und das Verfahren zur Prüfung des ESD-Verhaltens prüft eine Schaltung automatisch auf Schaltplanebene, indem technologiespezifische ESD-Daten für alle in der Schaltung auftretenden Komponenten in einer Datenbank bereitgestellt und zur Auswertung des ESD-Verhaltens herangezogen werden, ohne dass aufwändige Schaltungssimulationen erforderlich sind. Nicht nötig sind die Simulation auf beispielsweise Basis von Frontend- oder Backend-Daten, unter Berücksichtigung von "Parasites" im Layout.

Weitere vorteilhafte Ausführungsformen sind der weiteren Beschreibung zu entnehmen. Mit Bezug zu den Zeichnungen werden weitere Ausführungsbeispiele detaillierter beschrieben.

Weitere vorteilhafte Ausführungsformen (Beispiele) sind der weiteren Beschreibung zu entnehmen. Mit Bezug zu den Zeichnungen werden nunmehr weitere Ausführungsbeispiele detaillierter beschrieben.
- Figur 1: ist eine schematische Darstellung eines Systems 1 zur Prüfung des ESD-Verhaltens auf Schaltungsebene (ESD-Checker) gemäß einer anschaulichen Ausführungsform.
- Figur 2a: ist eine Strom-Spannungscharakteristik eines PMOS-Transistors in linearisierter Form, wie sie zur Gewinnung der parametrisierten ESD-Daten verwendet werden kann.
- Figur 2b: ist eine Strom-Spannungscharakteristik eines NMOS-Transistors in linearisierter Form, wie sie zur Gewinnung der parametrisierten ESD-Daten verwendet werden kann.
- Figur 3a: bis
- Figur 3e: sind schematische Schaltbilder mit ermittelten Entladepfaden zur Beschreibung der Funktionsweise der Beispiele des erfindungsgemäßen Systems.

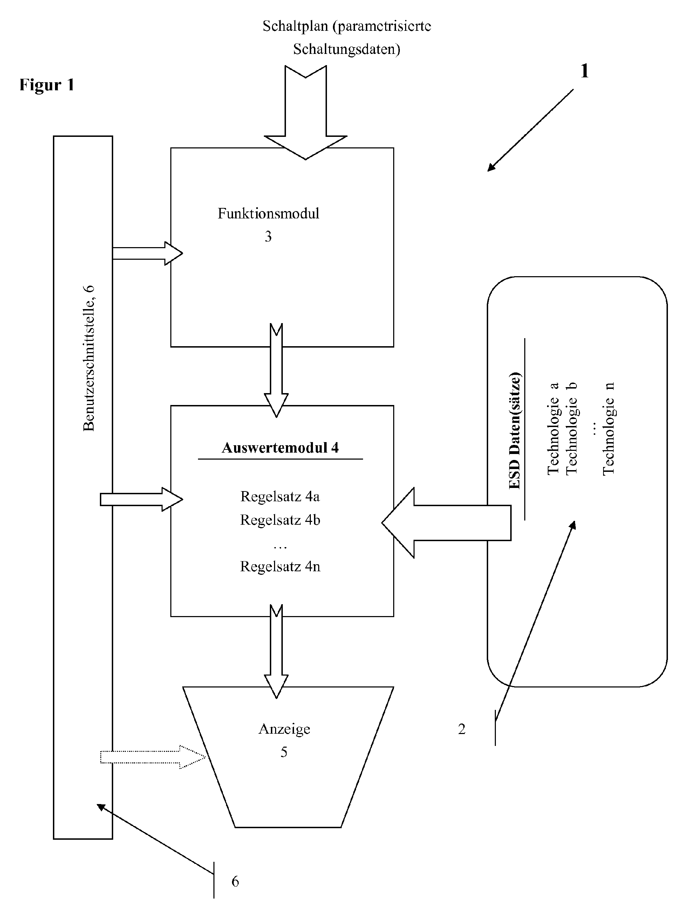

**Figur 1** zeigt schematisch ein System 1 zur Prüfung des Verhaltens einer Schaltung bei Auftreten einer elektrostatischen Entladung, das auch als ESD-Design-Checker bezeichnet wird. Das System 1 umfasst eine Datenbank 2, die einen oder mehrere parametrisierte Datensätze 2a, ..., 2n speichert, wovon jeder das ESD-Verhalten von zumindest einer Schaltungskomponente gemäß einer spezifizierten Technologie beschreibt.

Vorteilhaft ist jeder Datensatz 2a, ..., 2n ein "vollständiger" Datensatz in dem Sinne, dass jede in einer zu prüfenden Schaltung auftretende Schaltungskomponente auch mit ihren ESD-Kennwerten in Form von Schwellwerten, etc. vertreten ist.

Die parametrisierten Daten für das ESD-Verhalten können durch Messung unter Verwendung von geeignet gestalteten Stimulations-Strompulsen gewonnen werden, indem die Antwort des Bauelements ausgewertet wird. Auch die Strom-Spannungscharakteristik von Bauelementen kann durch geeignete Parametrisierung verwendet werden, wie dies nachfolgend für MOS-Transistoren näher erläutert wird.

Die ESD-Datensätze 2a, ..., 2n können gegebenenfalls auch durch Simulation der einzelnen Bauelemente gewonnen werden, wenn ein entsprechendes Modell für ein einzelnes Bauelement verfügbar ist. Es werden die Bauelemente einschließlich ihrer parasitären Komponenten in den einzelnen Datensätzen berücksichtigt. Andere parasitäre Komponenten, die sich im Layout durch Kombination von Grundbauelementen ergeben, können gegebenenfalls in Form von z.B. erwarteten Leitungswiderständen in Signalpfaden oder Buswiderstände des Power-Supply-Routings durch Metallwiderstände berücksichtigt werden. Die parametrisierten ESD-Charakteristiken in Form der Datensätze 2a, ... 2n umfassen damit das ESD-Verhalten von einfachen PN-Übergängen und Widerständen, das Verhalten von Gateoxiden sowie komplexes Snap-Back-Verhalten, d.h., die Strom-Spannungscharakteristik, der parasitären Komponenten von MOS-Transistoren. Durch die Bündelung aller technologiespezifischen Daten in der Datenbank 2 ist das System 1 (ESD-Design-Checker) technologieunabhängig und kann, wenn mehrere Datensätze 2a, ..., 2n implementiert sind, in Verbindung mit anderen Technologien verwendet werden.

Das System 1 umfasst ferner ein Funktionsmodul 3, das ausgebildet ist, automatisch die funktionelle Anordnung von Schaltungskomponenten zu erfassen, wobei dies durch parametrisierte elektrische Schaltungsdaten erfolgen kann, die den "Schaltplan" der Schaltung, also die Bauelemente und deren elektrische Verbindung untereinander repräsentieren.

Des weiteren ist ein Auswertemodul 4 vorgesehen, das mit dem Funktionsmodul 3 und der Datenbank 2 verbunden ist. In dem Auswertemodul 4 erfolgt eine Verknüpfung der die Schaltung repräsentierenden elektrischen Daten, die vom Funktionsmodul 3 bereitgestellt werden, mit den aus der Datenbank 2 abgerufenen ESD-Daten 2a, ...,2n, wobei der für die betreffende Technologie erforderliche Datensatz verwendet wird, wenn mehrere Technologien in der Datenbank 2 vorhanden sind, also mehrere Datensätze. Durch diese Verknüpfung wird den einzelnen Schaltungskomponenten, die vom Funktionsmodul 3 identifiziert werden, ein technologiespezifisches ESD-Verhalten verliehen, das für die Schaltung als ganzes oder für gewünschte Signalwege von dem Modul 4 ausgewertet wird.

Es kommen geeignete Auswerteregeln zur Anwendung. Durch das implementierte Regelwerk werden wahrscheinliche ESD-Entladepfade ermittelt, ohne dass eine ESD-Schaltungssimulation sowie Kompaktmodelle benötigt werden. Beispielsweise können die implementierten Regeln eine Unterscheidung von "gewöhnlichen" Schaltungskomponenten und von ESD-Schutzstrukturen bewirken.

High-Voltage-Anwendungen verwenden häufig ESD-Schutzschaltungen mit durch Gate-Bias getriggerten HV-NMOS-Transistoren.

Das Auswertemodul 4 kann in einer Ausführungsform solche Schaltungsstrukturen erkennen und behandelt sie entsprechend als Makro-Block mit spezieller Snap-Back-Charakteristik. Andere Regeln können beispielsweise das Ermitteln möglicher Entladungsstrecken und das Auswählen einer oder mehrerer Entladungsstrecken mit der geringsten Spannungsfestigkeit und/oder Stromfestigkeit als wahrscheinliche Entladungspfade beinhalten.

In einer Ausführungsform sind mehrere unterschiedliche Regelsätze 4a,..., 4n implementiert, die nach Bedarf ausgewählt werden können. Die einzelnen Regelsätze können dabei zu unterschiedlichen Auswerteergebnissen führen, so dass eine allgemeinere Aussage über das ESD-Verhalten der gleichen Schaltung möglich ist. So können die unterschiedlichen Regelsätze 4a, ..., 4n auf unterschiedliche ESD-Modelle abgestimmt sein, um damit mit jeweils demselben Datensatz 2a, ...,2n das Verhalten in Bezug auf unterschiedliche ESD-Situationen bewerten zu können.

Somit ist es möglich, für eine einzelne Schaltung oder einen kompletten IC mit komplexer Hierarchie einen "virtuellen" ESD-Test zwischen beliebigen Anschlusspunkten bzw. Pin-Kombinationen durchzuführen. Die Ausgabe des Ergebnisses der ESD-Analyse der Schaltung kann dabei graphisch durch Markieren des ermittelten ESD-Strompfades sowie durch Ausgabe der berechneten ESD-Festigkeit als Beispiele für das ESD-Verhalten kennzeichnende Parameterwerte für die gewählte Pin-Kombination erfolgen.

Dazu ist eine Anzeigeeinrichtung 5 vorgesehen, die zumindest mit dem Auswertemodul 4 verbunden ist. Als weiterer Parameterwert kann die Spannung am IC-Pin und der ESD-Entladestrom ausgegeben werden. Dabei kann eine Kommunikation mit dem System 1 über eine Benutzerschnittstelle 6 erfolgen, um etwa einen geeigneten Regelsatz 4a, ..., 4n auszuwählen, falls unterschiedliche Regeln implementiert sind, oder um eine spezielle Technologie, d.h., den Datensatz 2a,..., 2n auszuwählen. Es kann auch eine Kommunikation mit dem Funktionsmodul 3 erfolgen, wenn beispielsweise eine Modifikation des Schaltplans erfolgen soll, um etwa Schutzkomponenten einzufügen oder abzuändern, oder um parasitäre technologieabhängige Effekte in Form von zusätzlichen Widerständen zu berücksichtigen. Nach der Identifizierung wahrscheinlicher ESD-Schwachstellen ist es dem Schaltungsentwickler möglich, verschiedene Lösungen zur Verbesserung der ESD-Festigkeit experimentell oder virtuell zu testen.

Bei der Schaltungsanalyse wird vorzugsweise das gewählte ESD-Schutzkonzept, Padbasiert oder Power-Rail-basiert berücksichtigt. Dies wird z.B. vom Benutzer durch die Auswahl vordefinierter oder in ihren Parametern konfigurierbarer Power-Supply-Clampstrukturen über die Schnittstelle 6 spezifiziert.

Bei Pad-basierendem ESD-Schutz werden bidirektionale Schutzstrukturen verwendet, die die Entladung ableiten. Als Schutzstrukturen werden vorzugsweise Bauelemente mit tiefer Snap-Back-Charakteristik verwendet. Bei Kombinationen von Bauelementen mit tiefer Snap-Back-Charakteristik und ähnlichem Triggerverhalten ermittelt das Auswertemodul 4 durch Anwendung eines entsprechenden Regelsatzes den kritischen ESD-Pfad, der sich durch das Auslösen des Bauelementes mit der geringsten ESD-Festigkeit ergeben kann. Für Bauelemente, die die Bedingungen für gleichmäßiges Triggern, Vₜ₁ < Vₜ₂ erfüllen, kann das Auswertemodul 4 auch mehrfaches Triggern beim Ermitteln der ESD-Festigkeit berücksichtigen.

Gemäß einem weiteren Regelsatz wird für den rail-basierenden ESD-Schutz zugrunde gelegt, dass in diesem Fall in Flussrichtung betriebene Dioden in Verbindung mit Power-Supply-Clamps, also Einrichtungen zum Verbinden des Entladepfads mit den Versorgungsspannungsleitungen, zur Ableitung von ESD-Pulsen über die Versorgungsspannungsleitungen genutzt werden. Das ESD-Verhalten wird dabei im Wesentlichen durch den Serienwiderstand der Dioden, den Einschaltwiderstand der Power-Clamps, bspw. Spannungsbegrenzer (wie Dioden), und den parasitären Widerstand der Versorgungsspannungsleitungen bestimmt. Für den "virtuellen" ESD-Test ist das Definieren der Parameter der Power-Clamp bzw. Klemmeinrichtungen durch die Datensätze 2a,...,2n notwendig. Für die Dioden wird eine Abschätzung des ESD-Verhaltens mittels der spezifizierten Parameter, bspw. Fläche, Umfang, durchgeführt.

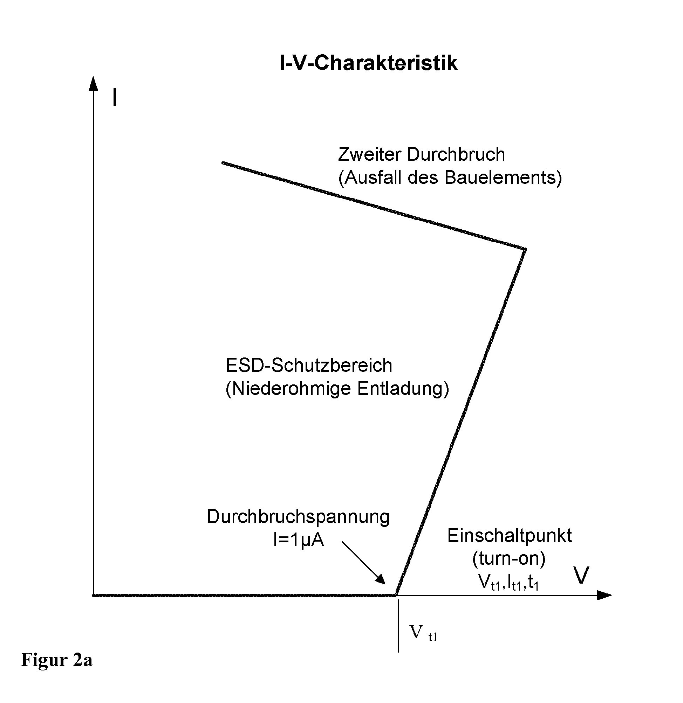

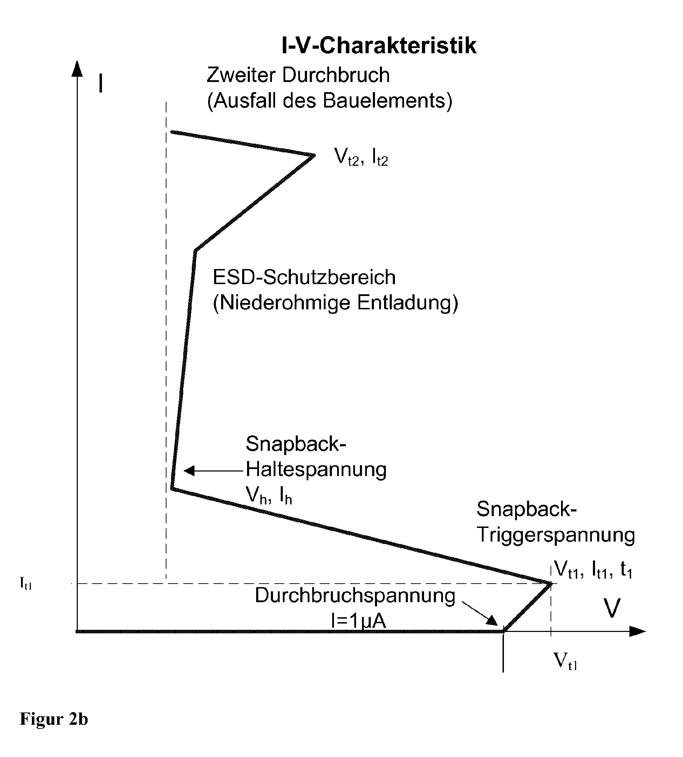

Mit Bezug zu den Figuren 2a und 2b sei das "Snap-Back"-Verhalten von MOS-Transistoren kurz erläutert. MOS Transistoren zeigen unter ESD-Stress typischerweise ein Snap-Back-Verhalten, d.h., bei Auftreten einer hohen Spannung tritt ein Avalanche-Durchbruch an einem PN-Übergang auf, der damit einen durch Source, Drain und das Substrat gebildeten parasitären Bipolartransistor einschaltet und leitend hält. Unterschieden werden kann dabei zwischen schwachem Snap-Back, das typischerweise bei PMOS-Transistoren auftritt und dem tiefen Snap-Back von NMOS-Transistoren.

Wie Figur 2a zeigt, findet bei einer Durchbruchsspannung Vₜ₁ beim PMOS-Transistor eine sprunghafte Änderung des Widerstands statt, so dass dieser niederohmige Bereich bei Ableitung von Entladeströmen benutzt werden kann. Bei einer höheren Spannung Vₜ₂ tritt der zweite Durchbruch auf, der zu einer Zerstörung des Bauelements führt und vermieden werden muß.

In Figur 2b ist das entsprechende tiefe Snap-Back-Verhalten eines NMOS-Transistors gezeigt, wobei nach dem ersten Durchbruch bei geringfügig höherer Spannung das Snap-Back-Verhalten bei Vₜ₁, 1ₜ₁ einsetzt und bei Vₕ in die sehr niederohmige Phase übergeht, woran sich eine Phase mit erhöhten Widerstand anschließt, bevor schließlich der zweite Durchbruch bei Vₜ₂, Iₜ₂ erfolgt, der zur Zerstörung des Bauelements führt.

Dieses Verhalten wird in einer Ausführungsform stückweise linear approximiert. Parameter dabei sind Durchbruchspannung, Snap-Back Triggerspannung und Strom, Clamping-Spannung bzw. Haltespannung sowie die Ausfallgrenze des Bauelementes bestimmt durch den zweiten Durchbruch.

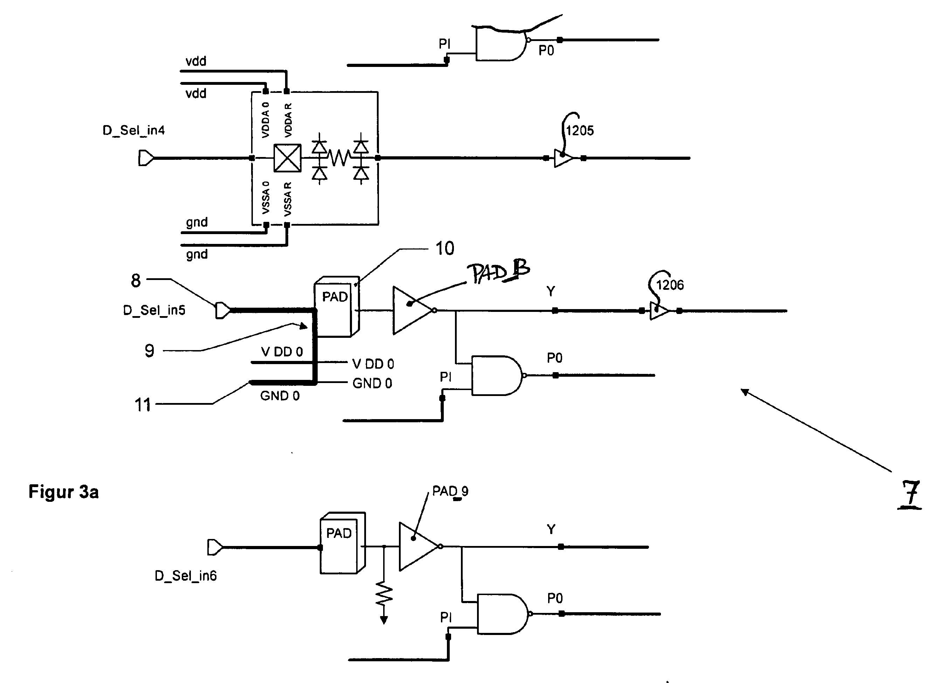

Mit Bezug zu den **Figuren 3a bis 3f** werden nun einige Anwendungsbeispiele des Systems 1 und des Verfahrens zum Betreiben desselben beschrieben.

Als erstes Beispiel wird eine Schaltung für ein Mixed-Signal-Design verwendet, also eine Schaltung mit analogen and digitalen Schaltungsbereichen, eines Low-Voltage Testchips, bspw. bei Spannungen von unter ca. 10 V, in der 0,6 µm Hochvolt-CMOS-Technologie verwendet wird. Zwei Varianten dieses Testchips mit Rail-basiertem und Pad-basiertem ESD-Schutz werden im Folgenden betrachtet. Beide Varianten verwenden digitale und analoge Standard-Library-Zellen.

**Figur 3a** zeigt ein erstes Beispiel einer Schaltung 7 im Entwurfsstadium, wie sie bspw. auf der Anzeigeeinrichtung 6 entsprechend einer abstrakteren Schaltplanebene dargestellt werden kann. Zur Demonstration der Funktionsweise des Systems 1 dient ein digitaler Eingangspin 8 mit implementiertem Pad-basierten ESD-Schutzkonzept, so dass ein Signalweg 9 zwischen einer Anschlussfläche bspw. als Pad 10 und einer Masseleitung 11 auf sein ESD-Verhalten untersucht werden soll.

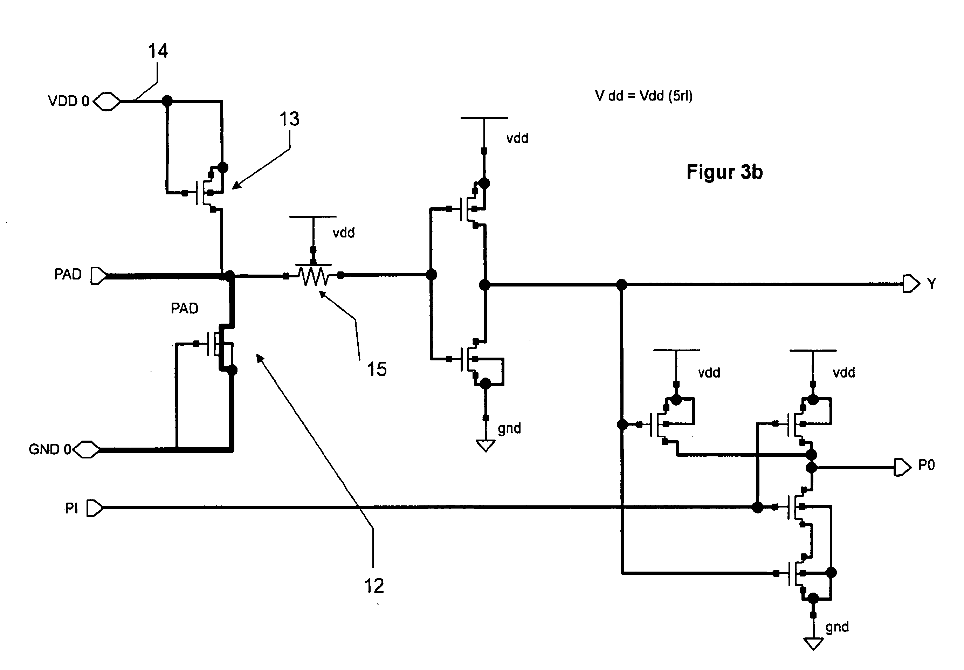

**Figur 3b** zeigt die Schaltung 7 in einer tieferen Abstraktionsstufe, wobei die Schaltung auf Transistorebene gezeigt ist. Als primäre ESD-Schutzstruktur wird ein NMOS Transistor 12 mit auf Masse liegendem Gate (ggNMOS/ggPMOS) verwendet. Analog ist ein PMOS-Transistor 13 vorgesehen, dessen Gate mit der positiven Versorgungsleitung 14 verbunden ist und der eine Entladestrecke zur positiven Versorgungsspannung bildet, die aber in diesem Beispiel nicht betrachtet wird. Der NMOS Transistor 12 besitzt beispielsweise eine ESD-Implantation zur Verbesserung seiner ESD-Festigkeit. Zusätzlich ist ein Serienwiderstand 15 im Eingangskreis verwendet.

Für den "virtuellen" ESD-Test mit dem System 1 wird zunächst die üblicherweise kritische ESD-Entladung mit positiver Polarität vom Eingangspin gegen Masse gewählt. Mit dem System 1 wird für diese ein ESD-Entladepfad über den primären NMOS ESD-Transistor 12 nach Masse ermittelt. Eine berechnete Pad-Spannung von 11,2 V zeigt, dass der Transistor 12 im Snap-Back arbeitet, siehe dazu Figur 2b. Die berechnete ESD-Festigkeit ist 4,5 kV mit einem ESD-Entladestrom von 3 A. Für eine ESD-Entladung mit negativer Polarität wird ebenfalls ein ESD-Entladepfad über den ESD-NMOS 12 ermittelt aber mit einer wesentlich höheren ESD-Festigkeit bzw. einem höheren Entladestrom. Die ermittelte niedrige Pad-Spannung zeigt, dass die parasitäre Drain-Bulk-Diode des NMOS aktiv ist. Die Größe dieser Diode, die ihre ESD-Festigkeit bestimmt, wird entsprechend den gültigen technologieabhängigen Entwurfsrichtlinien bzgl. des minimalen Abstandes von Substrat- und Wannenkontakten zu Source und Drain-Diffusionsgebieten von MOS-Transistoren der entsprechenden Technologie berechnet; dies aus technologiespezifischen Daten, die Teil der Datensätze 2a,..2n oder der Regelsätze 4a, ..,4n sein können, sowie den für den NMOS 12 im Schaltplan spezifizierten Layoutparametern, die durch die in das Funktionsmodul eingespeisten Daten verfügbar sind. Diese Ergebnisse zeigen, dass der positive Puls der kritischere Fall ist.

Zur weiteren Darstellung der Ergebnisse kann der ermittelte Entladepfad markiert werden. Diese Form der Darstellung ermöglicht es vom Top-Level ausgehend, siehe Figur 3a, den Entladepfad durch die Hierarchien zu verfolgen, bis auf Transistorlevel der **Figur 3b****.**

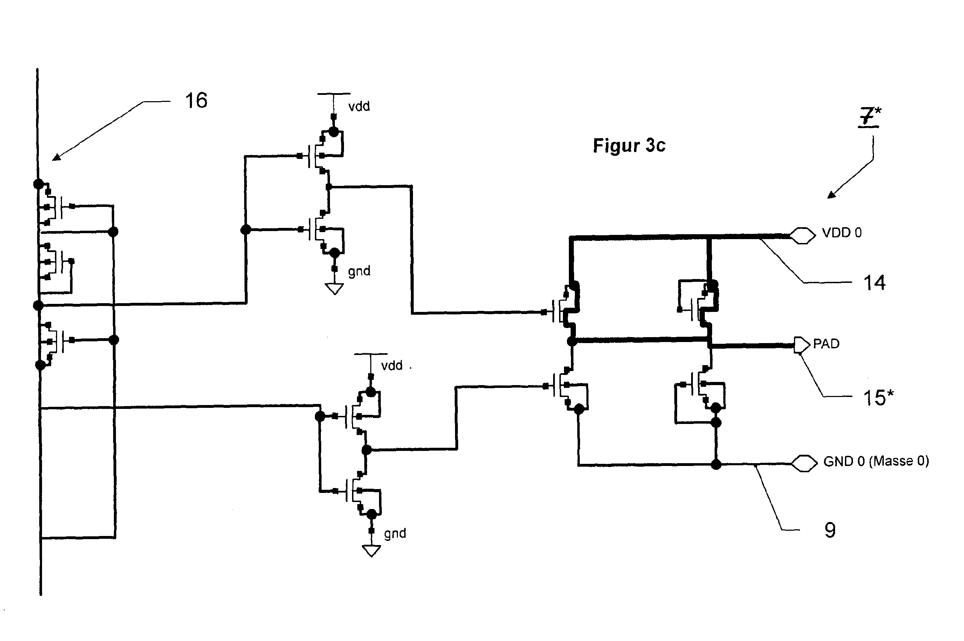

In **Figur 3c** wird als zweites Beispiel eine Entladung an einem Ausgangspin 15* eines Schaltkreises 7*, der in diesem Fall mit Rail-basierendem ESD-Schutz ausgestattet ist, gewählt. Als Power-Clamp bzw. ESD-Schutzelement der Versorgungsleitungen 14, 9 kommt ein durch einen RC-Timer 16 getriggerter BIGFET-Schalter zum Einsatz (nicht gezeigt). Diese Struktur wird als ESD-Schutzelement der Versorgungsleitungen durch die Benutzerschnittstelle 6 festgelegt. Die Benutzerschnittstelle bietet die Möglichkeit, selbst das ESD-Schutzelement der Versorgungsleitung zu definieren oder aus vordefinierten empfohlenen ESD-Schutzelementen zu wählen.

Diese Clampschaltung ist im ESD-Fall schon bei niedrigen Spannungen aktiv. Dadurch werden der Durchbruch und das Snap-Back der ESD-empfindlichen NMOS-Transistoren vermieden.

Für den "virtuellen" Test vom Ausgangspin 15* gegen Masse 9 wird ermittelt, dass die Entladung über die beiden Drain-Bulk-Dioden zur Power-Clamp verläuft. Dabei wird eine ESD-Festigkeit von 5 kV gemäß HBM (Messung) durch das System 1 ermittelt.

In zwei weiteren Beispielen soll auf Hochvolt-Bauelemente und aktive Clampstrukturen eingegangen werden.

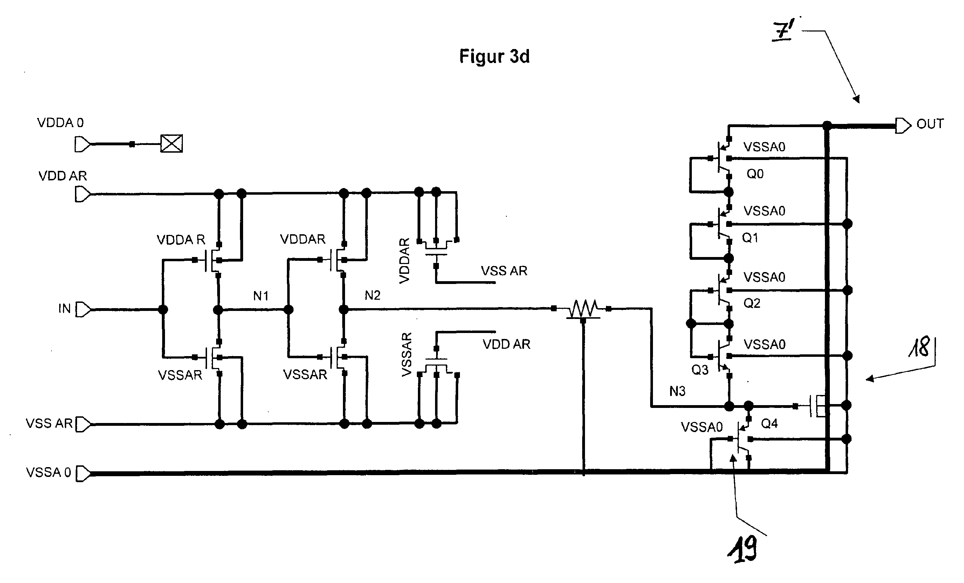

**Figur 3d** zeigt einen HV-LowSide-Treiber als Schaltung 7'. Die Schaltung 7' dient zur Ansteuerung eines masse-seitigen Leistungstransistors (nicht gezeigt). Bei dieser Treiberschaltung 7' ist zur Ermöglichung des ESD-Selbstschutzes ein aktives Clamping implementiert.

Eine Triggerschaltung 19 mit Abbildung aller Bipolartransistoren, auch die zwischen Pad und Gate des HV-NMOS 18 ist vorgesehen. Die gesamte Schaltung mit BJT zwischen Drain und Gate und Gate und Source ist dargestellt.

Dazu wird ein Teil des ESD-Pulses von der Triggerschaltung 19 zur Ansteuerung des Gates des HV-NMOS Open-Drain-Transistors 18 verwendet. Die Tiggerschaltung 19 beeinflusst dabei entscheidend das ESD-Verhalten des HV-NMOS Transistors 18. Dies wird durch das System 1 bei der Berechnung der ESD-Festigkeit entsprechend berücksichtigt.

Das vom System 1 verwendete Hochstromverhalten der gezeigten Clampstruktur ist dabei generell verschieden von dem eines einfachen Hochvolt-NMOS Transistors. Bei der Schaltungsanalyse wird durch das System 1 erkannt, dass es sich bei der Kombination aus Bipolartransistoren 19 und Hochvolt-NMOS Transistor 18 um eine aktive Clampschaltung handelt. Die entsprechenden Komponenten werden zu einem Makro-Block zusammengefasst und ein in der Datenbank 2 abgelegtes ESD-Verhalten zugewiesen. Dessen Durchbruchspannung wird durch die Triggerschaltung 19 der Bipolartransistoren bestimmt. Für die Clampschaltung wird mittels des Systems 1 eine ESD-Festigkeit von über 10 kV ermittelt.

Messungen an einem realen Aufbau dieser Struktur ergaben, einen HBM-Strom von mehr als 8 A ohne nachweisbare Beschädigung der Schaltung. Somit können die Ergebnisse des Systems 1 als bestätigt angesehen werden.

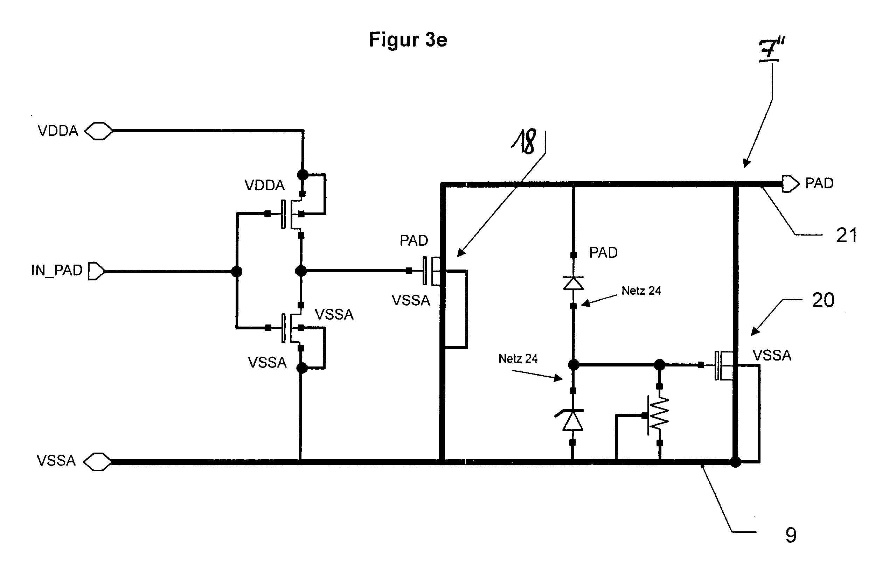

In Figur 3e ist ein weiteres Beispiel 7" der Schaltung 7 gezeigt, wobei der Open-Drain-Treiber keine integrierte Triggerschaltung besitzt. Hier wird eine aktive Clampschaltung 20 parallel zum Open-Drain-Treiber als ESD-Schutz verwendet.

Obwohl die Durchbruchspannung der aktiven Clampschaltung 20 auf einen Wert ausreichend unterhalb der Drain-Source-Durchbruchspannung des Open-Drain-Ausgangstreibers eingestellt ist, ermittelt das System 1 bei positiver ESD-Belastung vom Ausgang 21 zum Ground 9 (Masse) nur eine sehr geringe ESD-Festigkeit.

Als ESD-Schwachstelle wird der Open-Drain-Ausgangstreibertransistor 18 identifiziert. Die aktive Clampschaltung 20 erreicht für diesen keinen ausreichenden ESD-Schutz. Als Grund dafür ist die zu hohe Triggerspannung der aktiven Clampschaltung 20 zu benennen. Dadurch wird der ESD-empfindliche Ausgangstransistor 18 zerstört, bevor die ESD-Schutzschaltung 20 aktiviert wird und die Pad-Spannung auf einen ausreichend niedrigen Wert begrenzt. Durch den ESD-Design-Checker kann dieses Verhalten der Schaltung bereits in der Entwurfsphase auf Schaltungsebene erkannt werden.

Das erfindungsgemäße System und das Verfahren ermöglichen somit eine frühzeitige Einschätzung der ESD-Festigkeit von einzelnen Schaltungen und kompletten Integrierten Schaltkreise. Mit dem zuvor beschriebenen System und Verfahren können Schaltungsentwürfe schnell auf korrekte Implementierung verschiedener ESD-Schutzkonzepte geprüft und mögliche ESD-Schwachstellen frühzeitig bereits auf Schaltungsebene identifiziert werden. Die ESD-Daten können durch geeignete Messverfahren, z.B. TLP (transmission line pulse), also durch Beaufschlagung mit kurzen hohen Stromimpulsen, oder auch durch Simulation ermittelt werden.

Dabei werden in einer Abschätzung quantitative Informationen über die zu erwartende ESD-Festigkeit gegeben. Die Prüfung erfolgt innerhalb der Design-Umgebung und erfordert keine ESD-Schaltungssimulation unter Einbindung von Kompaktmodellen. Das System kann in CAD-Entwicklungsumgebungen implementiert werden. Beispielsweise kann das System mittels der Programmiersprache SKILL der Plattform Cadence DFII implementiert werden, wobei die Analyse auf Schaltplanebene (Cadence Schematic-View) erfolgen kann. In weiteren Ausführungsformen des Systems können Mittel zur Extraktion von Schaltkreis-Layouts vorgesehen sein, so dass damit auch eine Analyse von Schaltkreis-Layouts möglich ist.

## Patentansprüche

1. **Verfahren zur Prüfung** des Verhaltens einer Schaltung (7) im Entwurfsstadium in Bezug auf elektrostatische Entladungen, mit den Schritten
- Bereitstellen von parametrisierten Daten (2a, ..., 2n) in einer Datenbank (2), welche Daten das Verhalten bei elektrostatischer Entladung beschreiben, und jeder in der Schaltung (7, 7', 7") verwendete Schaltungskomponente ein Satz von Daten zugeordnet ist;
- Ermitteln von Schaltungskomponenten (12,13,18,19,20) in einem auf elektrostatische Entladung zu prüfenden Signalweg (8) der Schaltung (7,7',7");
- Abrufen der den ermittelten Schaltungskomponenten (12, 13, 18, 19, 20) zugehörigen parametrisierten Daten (2a,..., 2n) oder dem Datensatz aus der Datenbank (2);
- Bestimmen mindestens eines für das Verhalten bei elektrostatischer Entladung charakteristischen Parameterwertes für den zu prüfenden Signalweg (8) unter Benutzung der zugehörigen parametrisierten Daten bzw. des Datensatzes.

2. Verfahren nach Anspruch 1, wobei der mindestens eine charakteristische Parameterwert eine Entladungsfestigkeit zwischen Anschlusspunkten der Schaltung kennzeichnet.

3. Verfahren nach Anspruch 1 oder 2, wobei der mindestens eine charakteristische Parameterwert die Spannung und/oder den Strom an einem Anschlusspunkt des zu prüfenden Signalwegs kennzeichnet.

4. Verfahren nach einem der Ansprüche 1 bis 3, wobei ein Darstellen oder Anzeigen eines Entladungspfades für den zu prüfenden Signalweg umfasst ist.

5. Verfahren nach einem der Ansprüche 1 bis 4, wobei das Bestimmen des mindestens einen charakteristischen Parameterwertes umfasst: Ermitteln eines oder mehrerer Entladepfade durch Anwendung vordefinierter Auswerteregeln auf die abgerufenen parametrisierten Daten.

6. Verfahren nach einem der Ansprüche 1 bis 5, mit einem Auswählen eines in der Schaltung angewendeten Entladungsschutzkonzepts vor dem Bestimmen des mindestens einen charakteristischen Parameterwertes.

7. Verfahren nach Anspruch 6, wobei zwischen einem Schutzkonzept für eine Entladung über Anschlussflächen oder einem Schutzkonzept für eine Entladung über Zuleitungen der Versorgungsspannung ausgewählt wird.

8. Verfahren nach einem der Ansprüche 1 bis 7, wobei das Ermitteln der in dem Signalweg vorhandenen Schaltungskomponenten umfasst: Verwenden von parametrisierten Schaltungsdaten, die die elektrischen Eigenschaften der vorhandenen Schaltungskomponenten und deren Verbindungen untereinander spezifizieren.

9. Verfahren nach Anspruch 8, wobei die parametrisierten Schaltungsdaten mit den zugehörigen parametrisierten Daten verknüpft werden, um den mindestens einen charakteristischen Parameterwert zu bestimmen.

10. Verfahren nach Anspruch 8, das ferner umfasst: Zusammenfassen mehrerer Schaltungskomponenten als einzelne Entladungsschutzkomponente und Verknüpfen der einzelnen Entladungsschutzkomponente mit den für diese einzelne Entladungsschutzkomponente in der Datenbank (2) gespeicherten parametrisierten Daten.

11. Verfahren nach Anspruch 10, wobei die einzelne Entladungsschutzkomponente durch mehrere Bipolar-Transistoren und einen Hochvolt-NMOS-Transistor gebildet ist.

12. Verfahren nach einem der Ansprüche 1 bis 11, wobei durch Einprägen von Strompulsen in eine Schaltungskomponente und Auswerten einer Strom-Spannungscharakteristik der Schaltungskomponente parametrisierte Daten ermittelt werden, welche das bei elektrostatischer Entladung auftretende Verhalten beschreiben.

13. Verfahren nach Anspruch 12, wobei die Strompulse kurz sind, insbesondere als Impulse mit einer Zeitdauer von unter 500 nsec und/oder mit einer Stromstärke von unter 30 A eingeprägt werden, besonders im Bereich von mehreren 100 psec bis zu 100 nsec, und/oder im Bereich zwischen 1 A und 10 A.

14. Verfahren nach Anspruch 12 oder 13, wobei Abschnitte in der Strom-Spannungscharakteristik linearisiert werden, um die charakteristischen Daten zu ermitteln.

15. Verfahren nach einem der Ansprüche 1 bis 14, wobei die parametrisierten Daten einen ersten Datensatz (2a), der eine erste Fertigungstechnologie repräsentiert, und einen zweiten Datensatz (2b), der eine zweite, unterschiedliche Fertigungstechnologie repräsentiert, umfasst.

16. Verfahren nach einem der Ansprüche 1 bis 15, wobei die Schaltung den Entwurf einer vollständigen integrierten Schaltung repräsentiert.

17. **System zur Prüfung** des Verhaltens einer Schaltung (7) im Entwurfsstadium bei elektrostatischer Entladung, wobei das System umfasst:
- eine Datenbank (2), die für alle Schaltungskomponenten (12, 13, 18, 19, 20) der Schaltung (7) parametrisierte Daten (2a,...,2n) enthält, die das Verhalten jeder Schaltungskomponente (12, 13, 18, 19, 20) bei Einprägung eines Strompulses charakterisieren;
- ein Funktionsmodul (3) zur Identifizierung von Schaltungskomponenten (12, 13, 18, 19, 20) auf der Grundlage von parametrisierten Schaltungsdaten, die die elektrischen Eigenschaften der in der Schaltung (7) verwendeten Schaltungskomponenten (12, 13, 18, 19, 20) und der elektrischen Wechselwirkungen (8) untereinander beschreiben;
- ein Auswertemodul (4), das mit dem Funktionsmodul (3) gekoppelt ist und ausgebildet ist, parametrisierte Daten (2a,...,2n) für die Schaltungskomponenten (12, 13, 18, 19, 20) der Schaltung (7) aus der Datenbank (2) abzurufen, mit den parametrisierten Schaltungsdaten (2a,...,2n) zu verknüpfen und durch vordefinierte Regeln (4a,...,4n) aus den verknüpften parametrisierten Daten zumindest einen für das Verhalten bei elektrostatischer Entladung charakteristischen Parameterwert zu bestimmen.

18. System nach Anspruch 17 mit einer Benutzerschnittstelle (6), ausgebildet einen oder mehrere zu prüfende Signalwege (8) in der Schaltung (7) auszuwählen.

19. System nach Anspruch 17 oder 18, mit einer Anzeigeeinrichtung (5), auf der der mindestens eine charakteristische Parameterwert angezeigt oder dargestellt werden kann.

20. System nach einem der Ansprüche 17 bis 19, wobei die Datenbank (2) einen ersten Datensatz (2a), der eine erste Fertigungstechnologie repräsentiert, und einen zweiten Datensatz (2n), der eine zweite unterschiedliche Fertigungstechnologie repräsentiert, aufweist.

21. System nach Anspruch 17 oder Anspruch 18, wobei über die bzw. eine Benutzerschnittstelle (6) eine ESD-Testspannung und/oder ein ESD-Testmodell auswählbar ist.

22. System nach Anspruch 17, Anspruch 18 oder Anspruch 21, wobei über die Benutzerschnittstelle (6) ESD-Schutzelemente der Versorgungsleitung aus vordefinierten Makroblöcken auswählbar sind.

23. System nach Anspruch 17 oder Anspruch 22, wobei über die Benutzerschnittstelle (6) eigene Makroblöcke definierbar sind, zum Schutz der Versorgungsleitung(en).
